(19) Europäisches Patentamt / European Patent Office / Office européen des brevets

(11) **EP 2 820 435 B1**

(12) **EUROPEAN PATENT SPECIFICATION**

(45) Date of publication and mention
of the grant of the patent:
**20.04.2016 Bulletin 2016/16**

(51) Int Cl.:
***G01R 31/02*** *(2006.01)*    ***G01R 31/08*** *(2006.01)*
***H02H 7/26*** *(2006.01)*

(21) Application number: **12707995.2**

(22) Date of filing: **28.02.2012**

(86) International application number:
**PCT/EP2012/053344**

(87) International publication number:
**WO 2013/127438 (06.09.2013 Gazette 2013/36)**

(54) **A METHOD AND AN APPARATUS FOR DETECTING A FAULT IN AN HVDC POWER TRANSMISSION SYSTEM**

VERFAHREN UND VORRICHTUNG ZUR FEHLERERFASSUNG IN EINEM HDVC-STROMÜBERTRAGUNGSSYSTEM

PROCÉDÉ ET APPAREIL POUR DÉTECTER UN DÉFAUT DANS UN SYSTÈME DE TRANSMISSION D'ÉNERGIE HVDC

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**07.01.2015 Bulletin 2015/02**

(73) Proprietor: **ABB Technology Ltd.**
**8050 Zürich (CH)**

(72) Inventor: **JOHANNESSON, Niclas**
**S-771 33 Ludvika (SE)**

(74) Representative: **Ahrengart, Kenneth**
**ABB AB**
**Intellectual Property**
**Ingenjör Bååths Gata 11**
**721 83 Västerås (SE)**

(56) References cited:
**GB-A- 1 411 081    US-A1- 2009 085 574**

- **NAIDOO D ET AL: "A protection system for long HVDC transmission lines", POWER ENGINEERING SOCIETY INAUGURAL CONFERENCE AND EXPOSITION IN AFRICA, 2005 IEEE, IEEE, PISCATAWAY, NJ, USA, 11 July 2005 (2005-07-11), pages 150-155, XP031259850, ISBN: 978-0-7803-9326-4**
- **NAIDOO D ET AL: "HVDC line protection for the proposed future HVDC systems", POWER SYSTEM TECHNOLOGY, 2004. POWERCON 2004. 2004 INTERNATIONAL CONFE RENCE ON SINGAPORE 21-24 NOV. 2004, PISCATAWAY, NJ, USA,IEEE, US, vol. 2, 21 November 2004 (2004-11-21), page 1327, XP010811476, DOI: 10.1109/ICPST.2004.1460207 ISBN: 978-0-7803-8610-5**

## Description

### *Technical Field*

The present invention relates to a method for detecting a fault in a high voltage direct current, HVDC, power transmission system, the system comprising an internal part and an external part for carrying direct current, DC, where the internal part comprises at least one HVDC transmission or distribution line for carrying direct current, and the external part is separated from the internal part by means of at least one inductor. Further, the present invention relates to an apparatus for detecting a fault in the above-mentioned HVDC power transmission system, the apparatus comprising fault detection means for detecting a fault on the internal part, current determination means for determining the current carried by the HVDC transmission or distribution line, and voltage determination means for determining the voltage at a first location of the HVDC power transmission system. The present invention also relates to an HVDC power transmission system comprising an internal part and an external part for carrying direct current, where the internal part comprises at least one HVDC transmission or distribution line for carrying direct current, and the external part is separated from the internal part by means of at least one inductor, the system comprising at least one converter station arranged to convert alternating current, AC, to direct current for input to the at least one HVDC transmission or distribution line, and/or direct current to alternating current.

### *Background of the Invention*

A high voltage direct current, HVDC, power distribution network or an HVDC power transmission system uses direct current for the transmission of electrical power, in contrast to the more common AC systems. For long-distance transmission or distribution, HVDC systems may be less expensive and may suffer lower electrical losses. Since electric power generation takes place by means of alternating current/voltage (AC power), current must be converted into direct current for HVDC transmission or distribution, and direct current of an HVDC power transmission system must be converted to alternating current for input to a neighboring AC system. In general, an HVDC power transmission system comprises at least one HVDC transmission or distribution line for carrying direct current, DC, and converter stations for converting alternating current to direct current for input to the HVDC power transmission system and converter stations for converting direct current back to alternating current for input to an AC system. The at least one HVDC transmission or distribution line may comprise at least one long-distance HVDC link or cable for carrying direct current a long distance, e.g. under sea.

In general, an HVDC power transmission system may comprise an internal part and an external part for carrying direct current. The internal part comprises at least one HVDC transmission or distribution line for carrying direct current, and the external part is separated from the internal part by means of at least one inductor/reactor. The HVDC power transmission system may comprise a plurality of protective functions. One important protective function is the line fault protection. A fault on the internal part, also called an internal fault, e.g. a line fault, entails loss of the transmission or distribution capacity and therefore needs to be promptly corrected or addressed. A typical line fault, e.g. a short circuit, implies that a voltage decrease occurs and an increase in current occurs. A crucial step of the line fault protection is to determine that the fault is a fault on the internal part, i.e. to discriminate between a fault on the internal part and a fault on the external part, since a fault on the internal part is dealt with differently than a fault on the external part. A fault on the external part may e.g. be dealt with and handled by breakers of the external part. A fault on the internal part, which may be a pole-to-earth/ground fault, may e.g. be dealt with and handled by DC breaker/-s of the internal part or of the line, which is/are configured to disconnect the faulty line upon detection of a fault on the internal part. It is preferred to only disconnect the faulty line instead of disconnecting a larger part of the HVDC power transmission system, or the entire HVDC power transmission system, in order to minimize the effects on the power transmission or distribution and allow the faultless part of the system to continue transmitting power.

When a fault occurs on a transmission line, so called travelling waves arise which propagate in both directions, as viewed from the location of the fault. When these waves hit a converter station, the travelling waves are reflected and may bounce back and forth. The travelling waves arise both on AC and DC transmission lines and have, in prior art, been utilized for fault detection and fault positioning on transmission lines. A method using travelling waves for this purpose is disclosed in US 4,719,980.

US2009/0085574 discloses a method for locating phase to ground faults in DC distribution systems.

GB1297628 describes a DC line fault detector including means for monitoring the rate of change of the line voltage and means for monitoring the rate of change of the line current.

The article "The identification of Internal and External Faults for ±800kV UHVDC Transmission Line based on Mathematical Morphology" by SHU Hongchun et. al., pages 288-292, Faculty of Electrical Engineering, Kunming University of Science and Technology, Kunming, Yunnan Province, China, discloses an algorithm based on mathematical morphology for fast discrimination between an internal fault and an external fault.

WO99/63641 describes a method and a device for detection of a fault on a transmission line in a bipolar HVDC installation.

The Article "A protection system for long HVDC transmission lines" (NAIDOO D ET AL, POWER ENGINEERING SOCIETY INAUGURAL CONFERENCE AND EXPOSITION IN AFRICA, 2005 IEEE, 11 July 2005, pages 150-155) discloses a method for detecting a fault in a high voltage direct current, HVDC, power transmission system.

### *The Object of the Invention*

The inventor of the present invention has found that it is crucial for the line fault protection and for the power transmission of the high voltage direct current, HVDC, power transmission system, to determine in an efficient manner that a fault is a fault on the internal part of the system, i.e. to discriminate between a fault on the internal part and a fault on the external part of the system.

An object of the present invention is thus to improve the detection of a fault in an HVDC power transmission system.

A further object of the present invention is to improve the detection of a fault on the internal part of the system.

Another object of the present invention is to improve the discrimination between a fault on the internal part and a fault on the external part.

### *Summary of the Invention*

The above-mentioned objects of the present invention are attained by providing a method for detecting a fault in a high voltage direct current, HVDC, power transmission system, the system comprising an internal part and an external part for carrying direct current, DC, where the internal part comprises at least one HVDC transmission or distribution line for carrying direct current, and the external part is separated from the internal part by means of at least one inductor, the method comprising the steps of:

- determining the current carried by the HVDC transmission or distribution line,
- determining the voltage at a first location of the HVDC power transmission system,
- determining the impedance based on the determined current and voltage,
- determining the derivative of the impedance, and
- detecting a fault on the internal part at least partially based on the derivative of the impedance.

By means of the method according to the present invention, an improved and more efficient detection of a fault in an HVDC power transmission system is attained, and an improved and more efficient detection of a fault on the internal part in relation to prior art methods is provided. By means of the method according to the present invention an efficient discrimination between a fault on the internal part and a fault on the external part is provided. By using the derivative of the impedance as a basis for detecting a fault on the internal part and for discriminating between a fault on the internal part and a fault on the external part, a more robust method for detecting a fault on the internal part, e.g. on the HVDC transmission or distribution line, is provided compared to prior art methods using derivatives of the voltage and current to detect a fault on the internal part. Thus, by using the derivative of the impedance as a basis for detecting a fault on the internal part, the innovative method is robust to transients at low voltage/high current. The use of active current-limiting devices comprising power semiconductor elements, e.g. IGBT, may enhance transient currents. By means of the innovative method, it is easier to discriminate between a fault on the internal part and a fault on the external part, especially when the internal part comprises a long-distance HVDC line, e.g. an HVDC line longer than 250 km. By using the derivative of the impedance as a basis for detecting a fault on the internal part, the inventor of the present invention has found that the innovative method is robust to distortion on long-distance HVDC lines. By means of the innovative method of the present invention, the protection of the HVDC power transmission system is enhanced, and the electric power transmission in an HVDC power transmission system and the control thereof are efficiently improved.

When a fault on the internal part, i.e. an internal fault, has been detected, the internal fault may be dealt with in manners known to the skilled person, e.g. by disconnecting the faulty internal part or the faulty line.

That the external part is separated from the internal part by means of at least one inductor implies that the at least one inductor forms a boundary between the internal part and the external part. The at least one inductor may connect the external part to the internal part. The internal part may have a plurality of terminal portions, each of which being connected to an external part by means of at least one inductor.

The at least one HVDC transmission or distribution line may be one or a plurality of lines, and may be an HVDC transmission line, e.g. a cable, an overhead line, or a long-distance HVDC link or cable, or mixtures thereof.

The step of determining the voltage may comprise determining the voltage at a first location on the internal part of the system, e.g. in the proximity of an inductor.

According to an advantageous embodiment of the method according to the present invention, the method comprises determining the current and the voltage during a period of time and determining the impedance for the period of time, wherein the method comprises determining the derivative of the impedance for the period of time, and wherein the derivative of the impedance for the period of time is used at least partially as a basis for detecting a fault on the internal part. By means of this embodiment, the detection of a fault on the internal part of the system is further improved.

The above-mentioned objects of the present invention are also attained by an apparatus for detecting a fault in an HVDC power transmission system, the system comprising an internal part and an external part for carrying direct current, DC, where the internal part comprises at least one HVDC transmission or distribution line for carrying direct current, and the external part is separated from the internal part by means of at least one inductor, the apparatus comprising

fault detection means for detecting a fault on the internal part,
current determination means for determining the current carried by the HVDC transmission or distribution line, and
voltage determination means for determining the voltage at a first location of the HVDC power transmission system, wherein the apparatus comprises

impedance determination means for determining the impedance based on the determined current and voltage, and derivative determination means for determining the derivative of the impedance, and wherein the fault detection means are arranged to detect a fault on the internal part at least partially based on the derivative of the impedance.

The current determination means may be in the form of current determination equipment, the voltage determination means may be in the form of voltage determination equipment, the impedance determination means may be in the form of impedance determination equipment, the derivative determination means may be in the form of derivative determination equipment, and the fault detection means may be in the form of fault detection equipment.

Positive technical effects of the apparatus according to the present invention, and its embodiments, correspond to the technical effects mentioned in connection with the method according to the present invention, and its embodiments.

According to an advantageous embodiment of the apparatus according to the present invention, the current determination means comprises current measuring means for measuring the current carried by the HVDC transmission or distribution line. The current measuring means may be in the form of conventional current measuring equipment known to the person skilled in the art.

According to a further advantageous embodiment of the apparatus according to the present invention, the voltage determination means comprises voltage measuring means for measuring the voltage at the first location of the HVDC power transmission system. The voltage measuring means may be in the form of conventional voltage measuring equipment known to the person skilled in the art.

According to another advantageous embodiment of the apparatus according to the present invention, the voltage measuring means are arranged to measure the voltage at a first location on the internal part.

According to yet another advantageous embodiment of the apparatus according to the present invention, the fault detection means are arranged to detect a fault on an internal part comprising at least one overhead line.

A plurality of the means of the apparatus according to the present invention may be implemented as at least one computer program product directly loadable into the internal memory of at least one digital computer comprising software code portions for performing the steps of the method according to any of the embodiments of the claims when said at least one product is/are run on said at least one computer. The apparatus may comprise a processor, e.g. a CPU.

The above-mentioned objects of the present invention are also attained by providing a high voltage direct current, HVDC, power transmission system comprising an internal part and an external part for carrying direct current, DC, where the internal part comprises at least one HVDC transmission or distribution line for carrying direct current, and the external part is separated from the internal part by means of at least one inductor, the system comprising at least one converter station arranged to convert alternating current, AC, to direct current for input to the at least one HVDC transmission or distribution line, and/or direct current to alternating current, wherein the system comprises at least one apparatus as claimed in any of the claims 11-17 and/or at least one apparatus according to any of the embodiments of the apparatus. Positive technical effects of the HVDC power transmission system according to the present invention, and its embodiments, correspond to the technical effects mentioned in connection with the apparatus or method according to the present invention, and their embodiments. The at least one HVDC transmission line may be one or a plurality of HVDC transmission lines.

According to an advantageous embodiment of the HVDC power transmission system according to the present invention, the system comprises a plurality of converter stations and a plurality of HVDC transmission or distribution lines.

A plurality of HVDC transmission or distribution lines or converter stations may be two or more HVDC transmission or distribution lines or converter stations, respectively. The at least one apparatus may be one or a plurality of apparatuses, e.g. two or more apparatuses. A plurality of apparatuses may be connected to the same HVDC transmission or distribution line, or to different HVDC transmission or distribution lines.

According to a further advantageous embodiment of the HVDC power transmission system according to the present invention, the system comprises at least three converter stations, or at least four converter stations, or at least five converter stations.

According to another advantageous embodiment of the HVDC power transmission system according to the present invention, the at least one HVDC transmission or distribution line comprises at least one long-distance HVDC link. Advantageously, the HVDC transmission or distribution lines may comprise at least two long-distance HVDC links or cables.

The various components of the apparatus and the system, respectively, according to the present invention, which are connected or connectable to one another or to other units, may be electrically connected, or connectable, to one another or to other units, e.g. via electrical conductors, e.g. busbars or DC lines, and/or may be indirectly connected, or connectable, e.g. electrically or inductively, via additional intermediate electric equipment or units located and connected/connectable between the components, e.g. a transformer, another converter etc.

In general, High Voltage may be about 1-1.5 kV and above. However, for HVDC applications and systems, High Voltage may be about 100 kV and above, e.g. 150 kV, 320 kV, 500 kV, 800 kV or 1000 kV, and above. The method, apparatus and the system according to the present invention are advantageously adapted for the above-mentioned HVDC voltage levels and above.

Further advantageous embodiments of the method, apparatus and system, respectively, according to the present invention and further advantages with the present invention emerge from the appended claims and the detailed description of embodiments

The features and embodiments of the method, apparatus and system, respectively, may be combined in various possible ways providing further advantageous embodiments.

### Brief Description of the Drawings

The present invention will now be described, for exemplary purposes, in more detail by way of embodiments and with reference to the enclosed drawings, in which:

Fig. 1    is a schematic diagram illustrating power transmission by means of an HVDC transmission line;

Fig. 2    is a schematic diagram illustrating power transmission by means of an HVDC power transmission system, having an HVDC transmission line, during steady state;

Fig. 3    is a schematic diagram illustrating an internal fault in the HVDC power transmission system illustrated in Fig. 2;

Fig. 4    is a schematic diagram illustrating a simulation of the direct current during steady state, where the magnitude of the ripple is shown;

Fig. 5    is a schematic diagram illustrating the output of the expression 2.4 for the internal fault measured 250 km from the fault;

Fig. 6    is a schematic diagram illustrating an external fault in the HVDC power transmission system illustrated in Fig. 2;

Fig. 7    are schematic diagrams showing simulation of the current and voltage as measured in the presence of an external fault and an internal fault, respectively, on a 250 km HVDC cable;

Fig. 8    is a schematic diagram showing the output of the expressions 2.4 and 2.9 and thus the impedance in the presence of an external fault and an internal fault, respectively, based on the determined current and voltage as shown in Fig. 7;

Fig. 9    is a schematic diagram showing the derivative of the determined impedance in the presence of an external fault and an internal fault, respectively;

Fig. 10    is a schematic view illustrating aspects of the apparatus and the system according to the present invention; and

Fig. 11    is a schematic flow chart illustrating aspects of the method according to the present invention.

### Detailed Description of Preferred Embodiments

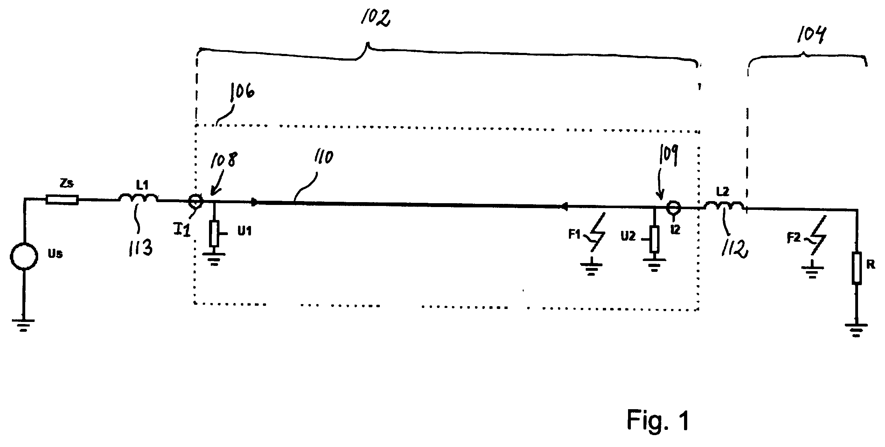

As previously mentioned above, a crucial step of line fault protection is to detect that a fault is a fault on the internal part, i.e. to discriminate between a fault on the internal part 102 and a fault on the external part 104 of a high voltage direct current, HVDC, power transmission system. With reference to Fig. 1, the internal part 102 may comprise an HVDC transmission or distribution line 110, hereinafter called HVDC line 110, e.g. a cable or overhead line. A protection zone 106 for the internal part 102 may extend from a first location 108, where direct current $I1$ is carried, to an inductor 112, also indicated as L2 in Fig. 1, connected at the other line end. In Fig. 1, the inductor 112 separates the external part 104 from the internal part 102 at a first end. Thus, the inductor 112 separates a fault on the external part 104, also called an external fault, from a fault on the internal part 102. A fault on the internal part 102 may also be called an internal fault, or a line fault. Consequently, voltage and current transients may be considered as a key to a protection scheme based on one-end measurements. In Fig. 1, one-end measurements for line fault protection may be made at the first location 108. In Fig. 1, $F1$ illustrates the location of an internal fault and F2 illustrates the location of an external fault.

If one-end measurements for line fault protection instead were made at a second location 109, where direct current *I2* is carried, at the first end close to the inductor 112, another inductor 113, also indicated as *L1* in Fig. 1, would be the inductor separating an external part from an internal part at a second end.

Voltage and current waves originating from a fault location will suffer distortion and attenuation as they travel along the HVDC line 110. Thus, after a certain distance along the HVDC line 110 and when applying prior art methods, the difference between an internal fault and an external fault may be too small to certainly identify the fault as either an internal fault or an external fault for one-end measurements at the first location 108. This limits the length of the HVDC line 110 for prior art methods, where a one-end measured protection is applied to cover an entire protection zone 106, which may correspond to the length of the HVDC line 110. In prior art, protection of long-distance HVDC lines, where the protection involves the step of discriminating between a fault on the internal part and a fault on the external part, is thus problematic, especially for one-end measured protection.

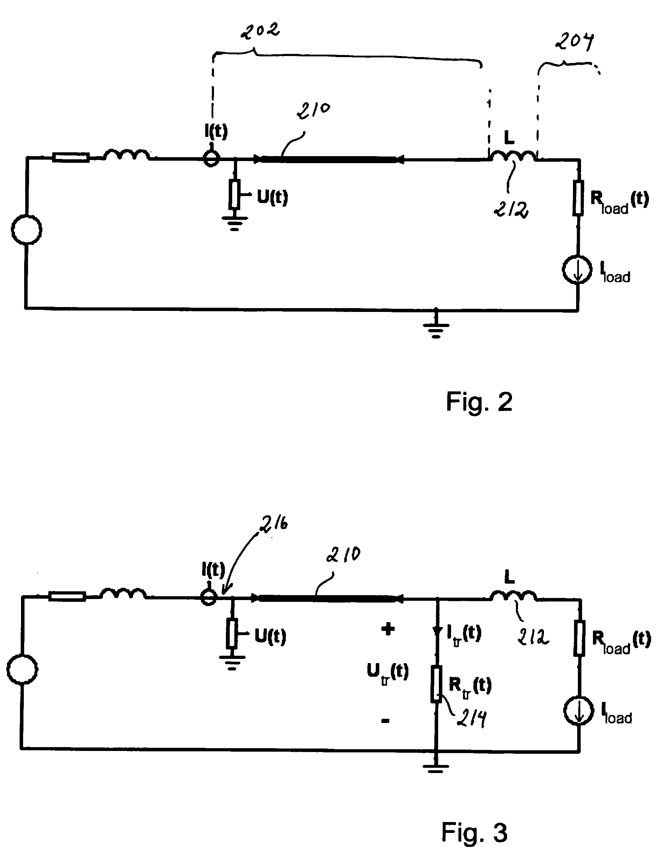

In the following, a background to the theory, on which the present invention is based, is disclosed with reference to Figs. 2-9.

With reference to Fig. 2, an HVDC power transmission system having an internal part 202 comprising an HVDC line 210, e.g. a HDCV cable, and an external part 204, in the forward direction, separated from the internal part 202 by an inductor 212 is schematically shown during steady state. The system is simplified for illustrative purposes. Here it is assumed that the HVDC line 210, e.g. a cable or an overhead line, is short so that the traveling time is negligible, which will simplify the notation of time. Further, it is assumed that the HVDC line 210 is a lossless transmission line, which implies that the voltage and current waves will not be exposed to any distortion as they travel along the HVDC line 210. Under these assumptions and for illustrative purposes, it can be concluded that the voltage and current on both ends of the HVDC line 210 will be the same at all times, allowing for conventional circuit theory to be applied. In reality, e.g. for a real transmission line, the above-mentioned simplifying assumptions are not valid.

During normal operation (no faults applied), resistors of infinite resistance (open circuit) can be considered between pole and ground in all possible future fault locations. When a fault occurs, the resistance of that particular resistor, which represents the fault location, will suddenly drop to a value close to zero (for a low-impedance fault). The idea, from which the present invention originates, is to monitor the fault resistance, to determine the rate of the resistance drop, and to determine if the fault is an internal fault or an external fault based on the rate of the resistance drop.

With reference to Fig. 3, an internal fault is schematically illustrated. With the assumption that the fault is resistive, in Fig. 3 an internal fault is represented as a resistor 214 ($R_{tr}$) connected between the end of the HVDC line 210 and ground, and located inside of the inductor 212, as shown in Fig. 3. Alternatively, the fault could also be represented by an inductor. The direct current *I(t)* and the voltage *U(t)* are measured at a first position 216. Based on the assumption that the voltage drop across the HVDC line 210 is zero at all times (short-circuited line), the following expressions 2.1 and 2.2 will hold:

$$U(t) = U_{tr}(t) \qquad\qquad (2.1)$$

$$I(t) = I_{tr}(t) + I_{load} \qquad\qquad (2.2)$$

Since the current source is constant, expression 2.2 at time *t=0* will result in the following expression 2.3:

$$I_{load} = I(0) - I_{tr}(0) \qquad\qquad (2.3)$$

The current flowing through the fault resistance 214 before the fault, $I_{tr}(0)$, would in the ideal case be zero. However, if is assumed that the steady-state current ripple is flowing in the same resistor, $I_{tr}(0)$ can be considered to be slightly larger than zero. The fault resistance can be calculated using the expressions 2.1-2.3, which results in the following expression 2.4 for an internal fault, where the expression is denoted as $Z_{tr}(t)$:

$$Z_{tr}(t) = R_{tr}(t) = \frac{U_{tr}(t)}{I_{tr}(t)} = \frac{U(t)}{I(t) - I_{load}} = \frac{U(t)}{I(t) - I(0) + I_{tr}(0)} \qquad (2.4)$$

If no ripple is present, then $I(t) = I_{load}$ and $I(0) = I_{load}$, which would result in a division by zero and thus an infinite $Z_{tr}$ (open circuit). *I(0)* represents the average of the current during the last couple of milliseconds. A delay should be used in the calculation since the value of *I(0)* should not change significantly during the fault transient (when the current rises). The window used for the average calculation should also be of enough size such that fast variations, e.g. caused by an active current-limiting device, e.g. an IGBT breaker, have small impact. An expression for calculating $I(0)$ at a certain sample n, using a window-length of N samples and a delay of d samples is shown in the following expression 2.5:

$$I_0[n] = \frac{1}{N} \sum_{m=n-d-N+1}^{n-d} I[m] \qquad (2.5)$$

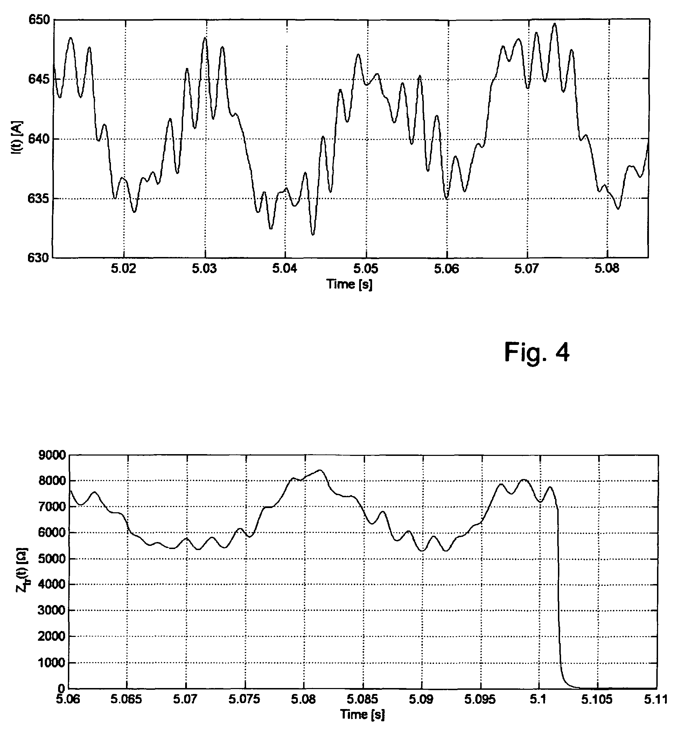

With reference to Figs 4-5 and 7-9, simulations are shown, where d = 100 and N = 200 in the expression 2.5 have been used, to further illustrate the theory on which the present invention is based. $I_{tr}(0)$ represents the transient current at a time zero. Since the ripple under normal conditions has comparably small amplitude, $I_{tr}(0)$ can be considered as a constant setting parameter, e.g. 50, or 100, or any other suitable number. Fig. 4 shows a simulation of the direct current during steady state where the magnitude of the ripple is shown. In Fig. 4, the direct current in the positive pole at a 400 MW transmission is schematically illustrated at steady state. The peak-peak magnitude of the ripple in Fig. 4 is about 20 A. To include some margins and thus improve the numerical performance, $I_{tr}(0)$ = 50 A has been used in the simulations shown in Figs. 5 and 7-9. The output of the expression 2.4 for an internal fault at the opposite side of a 250 km long HVDC line 210 is shown in Fig. 5. Before the fault, the transients cause the measured impedance to vary periodically. The impedance mean value in Fig. 5 is related to $I_{tr}(0)$, since 320 kV/50 A = 6.4 k$\Omega$ and 320kV/50$\pm$10 A = 5.3-8.0 kO. When the waves arrive at the measurements, at the first position 216, the impedance rapidly falls to a value close to zero.

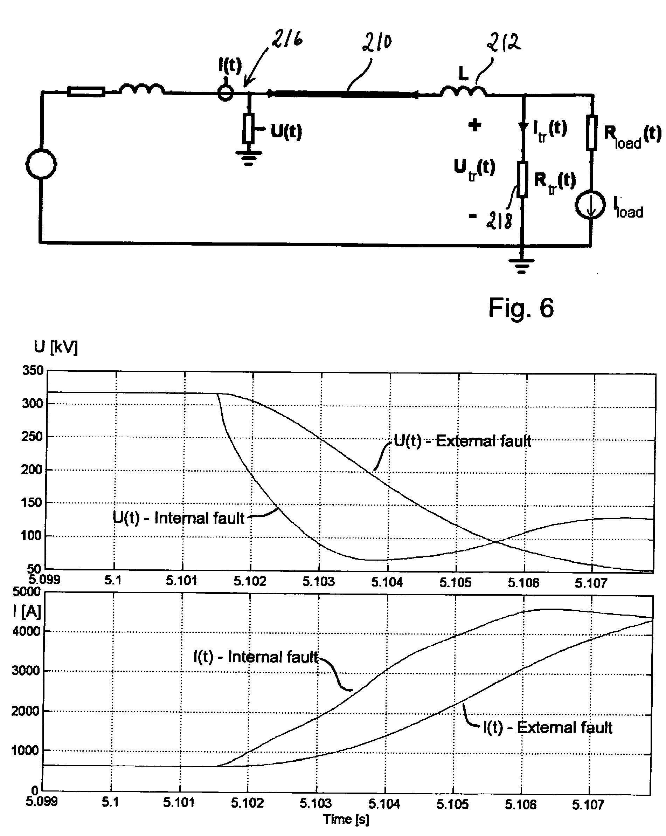

Applying the same assumptions and approach as for the illustration of an internal fault as disclosed above, the circuit for an external fault is schematically illustrated in Fig. 6. With the assumption that the fault is resistive, in Fig. 6 an external fault is represented as a resistor 218 ($R_{tr}$). Alternatively, the fault could also be represented by an inductor. The resistor 218 (i.e. the external fault) is located outside of the inductor 212 and located as shown in Fig. 6. The direct current $I(t)$ and the voltage $U(t)$ are measured at the first position 216. In the case of an external fault, the following expressions 2.6 and 2.7 will hold:

$$U(t) = U_{tr}(t) + U_L(t) \qquad (2.6)$$

$$I(t) = I_{tr}(t) + I_{load} \qquad (2.7)$$

Using the expressions 2.6 and 2.7 together with the expression 2.3, the following expression for the fault resistance is attained:

$$R_{tr}(t) = \frac{U_{tr}(t)}{I_{tr}(t)} = \frac{U(t)}{I(t) - I(0) + I_{tr}(0)} - \frac{U_L(t)}{I_{tr(t)}} \qquad (2.8)$$

Rearranging and identifying the expression derived from the illustration of an internal fault as disclosed above, the following expression 2.9 for an external fault is attained:

$$Z_{tr}(t) = \frac{U(t)}{I(t) - I(0) + I_{tr}(0)} = R_{tr}(t) + \frac{U_L(t)}{I_{tr}(t)} \qquad (2.9)$$

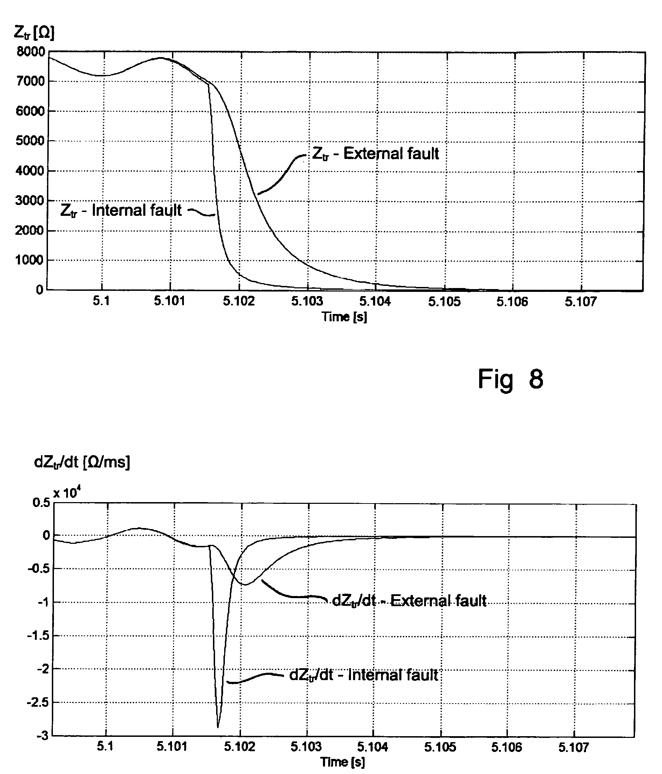

The result in the expression 2.9 can be interpreted as the fault resistance (which is known to drop instantaneously at the fault) connected in series with the impedance of the inductor 212 with respect to the fault current. The inductor 212 will limit the current derivative and thereby "absorb" the pre-fault voltage. This results in that the circuit initially, as seen from the line-side of the inductor 212, will continue to have the same impedance as pre-fault. However, the voltage over the inductor 212 will decrease with time as the current increases. This will result in an exponentially decreasing $Z_{tr}(t)$ compared to the sudden drop caused by an internal fault (see Fig. 8). The influence of the inductor 212 with regard to an external fault may be considered to be represented by $U_L(t)/I_{tr}(t)$ in the expression 2.9.

The difference between these two cases, i.e. internal fault and external fault, as illustrated above makes it possible to distinguish an internal fault from an external fault.

With reference to Fig. 7, simulations of the current and voltage as measured at the first position 216 in the presence of an external fault and an internal fault, respectively, on a 250 km HVDC cable are schematically plotted.

With reference to Fig. 8, the output of the algorithm described in expression 2.4, resulting in the impedance in the presence of an external fault and an internal fault, respectively, based on the determined current and voltage as shown in Fig. 7, is schematically plotted.

With reference to Fig. 9, the derivative of the determined impedance in the presence of an external fault and an internal fault, respectively, is calculated over four samples (at $T_s$ = 48 $\mu$s) and plotted. As Fig. 9 illustrates, the drop of the derivative of the impedance in the presence of an internal fault is enhanced several times compared to the drop of the derivative of the impedance in the presence of an external fault. In Fig. 9, at the drop there is a factor of margin of about 3.9 between the derivatives of the impedance for the internal fault and the external fault, respectively.

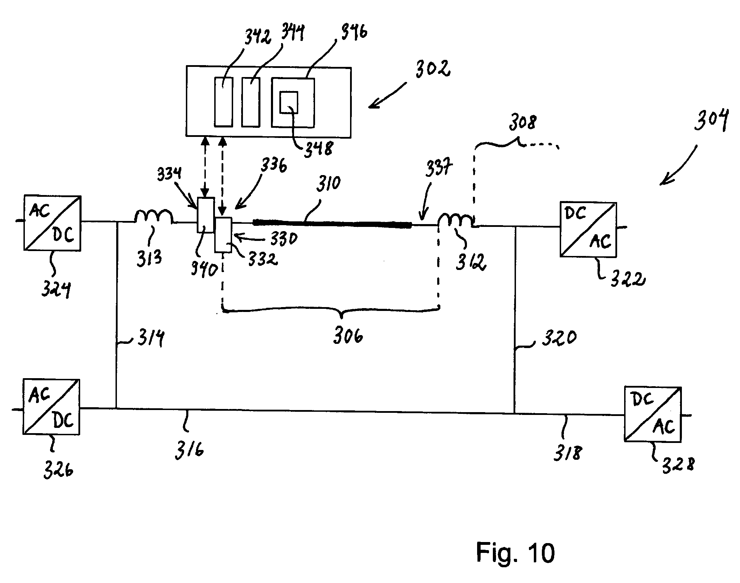

With reference to Fig. 10, aspects of the apparatus 302 for detecting a fault in an HVDC power transmission system 304 according to the present invention are schematically shown. For illustrative purposes, only one pole is illustrated. The system may be based on a bipole, symmetrical monopole, or asymmetrical monopole arrangement. The system 304 comprises an internal part 306 for carrying direct current, DC, and an external part 308 for carrying direct current. The internal part 306 comprises at least one HVDC line 310 for carrying direct current to which the apparatus 302 may be arranged to be connected. The at least one HVDC line 310 may be a cable, an overhead line, or any other line, or a mixture thereof. The external part 308 is separated from the internal part 306 by means of at least one inductor 312. The at least one inductor 312 may be one or more inductors. The system 304 may comprise one or a plurality of HVDC lines 310, 314, 316, 318, 320 and may comprise one or a plurality of converter stations 322, 324, 326, 328 each arranged to convert alternating current, AC, to direct current for input to the at least one HVDC line, and/or direct current to alternating current. Each HVDC line 310, 314, 316, 318, 320 may e.g. be a cable, an overhead line, or a long-distance HVDC link or cable, or mixtures thereof.

The apparatus 302 comprises current determination means 330 for determining the current carried by the HVDC line 310. The current determination means 330 may comprise current measuring means 332 for measuring the current carried by the HVDC line 310. The current measuring means 332 may comprise conventional current measuring equipment known to the person skilled in the art and are thus not disclosed in more detail. The apparatus 302 comprises voltage determination means 334 for determining the voltage at a first location 336 of the system 304. The current may also be measured at the first location 336. The voltage determination means 334 may comprise voltage measuring means 340 for measuring the voltage at the first location 336. Advantageously, the voltage measuring means 340 are arranged to measure the voltage at the first location 336 on the internal part 306, advantageously in the proximity of another inductor 313. Thus, advantageously, the first location 336 is on the internal part 306, advantageously close to the other inductor 313. The voltage measuring means 340 may comprise conventional voltage measuring equipment known to the person skilled in the art and are thus not disclosed in more detail.

When measurements are performed by means of the current determination means 330 and the voltage determination means 334 at the first location 336 close to the other inductor 313, the at least one inductor 312 separates the internal part 306 from the external part 308 at the other end of the HVDC line 310. If one-end measurements instead were made at a second location 337 close to the at least one inductor 312, the other inductor 313 would be the inductor separating an external part from an internal part of the system. The other inductor 313 could also be one or a plurality of inductors.

The apparatus 302 comprises impedance determination means 342 for determining the impedance based on the determined current and voltage. The apparatus 302 comprises derivative determination means 344 for determining the derivative of the impedance. The apparatus 302 comprises fault detection means 346 for detecting a fault on the internal part 306, the fault detection means 346 being arranged to detect a fault on the internal part 306 at least partially based on the determined derivative of the impedance.

The current and voltage determination means 330, 334 may be arranged to determine the current and the voltage, respectively, during a period of time. The impedance determination means 342 may be arranged to determine the impedance for that period of time. The derivative determination means 344 may be arranged to determine the derivative of the impedance for that period of time. The fault detection means 346 may be arranged to detect a fault on the internal part 306 at least partially based on the derivative of the impedance for that period of time. The fault detection means 346 may be arranged to detect a drop of the derivative of the impedance for the period of time, and the fault detection means 346 may be arranged to detect a fault on the internal part 306 at least partially based on the drop of the derivative of the impedance. The fault detection means 346 may be arranged to detect a fault on the internal part 306 if a first criterion, namely that when dropping, the derivative of the impedance drops by a set factor, is fulfilled. The voltage determination means 334 may be arranged to determine the voltage at a location 336 of the system 304 during the period of time. The fault detection means 346 may comprise comparison means 348 for comparing the voltage of the period of time, e.g. 1 ms, or 2 ms etc., with a set voltage level, and the fault detection means 346 may be arranged to detect a fault on the internal part 306 at least partially based on the comparison of the voltage of the period of time and the set voltage level. The fault detection means 346 may be arranged to detect a fault on the internal part 306 if a second criterion, namely that the voltage during the period of time, e.g. 1 ms, or 2 ms etc., is below the set voltage level, is fulfilled. The fault detection means 346 may be arranged to detect a fault on the internal part 306 if one or a plurality of additional criteria is fulfilled. The fault detection means 346 may be arranged to detect a fault on an internal part 306 comprising at least one overhead line. Alternatively, the fault detection means 346 may be arranged to detect a fault on an internal part 306 comprising at least one cable or any other line. The comparison means 348 and the second criterion may be excluded from the apparatus. The comparison means may be in the form of comparison equipment. Each of the above-mentioned means of the apparatus may be in the form of equipment or a unit.

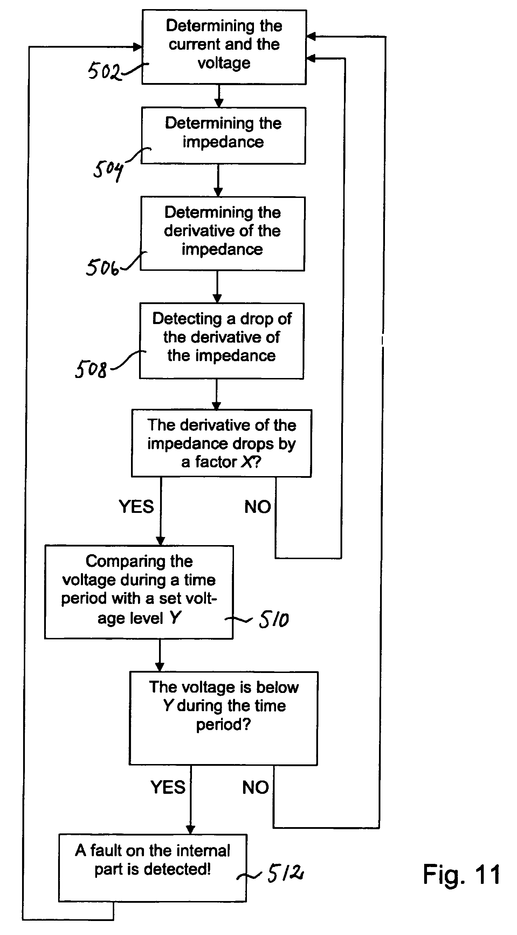

With reference Fig. 11, aspects of the method for detecting a fault in an HVDC power transmission system as disclosed above, according to the present invention are schematically shown. The method may comprise the following steps: The current carried by the HVDC line is determined, and the voltage at a first location of the system is determined, at step 502. Advantageously, the voltage is determined at a first location on the internal part of the system. The current may be determined by measuring the current carried by the HVDC line, and the voltage may be determined by measuring the voltage at the first location of the system during a period of time. Advantageously, the current is measured at a first location on the internal part of the system. Advantageously, the voltage is measured at a first location on the internal part of the system. Advantageously, the voltage is measured adjacent to an inductor. The impedance is determined based on the determined current and voltage, at step 504, and the derivative of the impedance is determined for the period of time, at step 506. A fault (an internal fault) is detected on the internal part at least partially based on the derivative of the impedance for the time period. More precisely, the stage of detecting a fault on the internal part may comprise detecting a drop of the derivative of the impedance for the period of time, at step 508, and the drop of the derivative of the impedance may be used at least partially as a basis for detecting a fault on the internal part. Advantageously, a fault on the internal part is detected if a first criterion, namely that when dropping, the derivative of the impedance drops by a set factor X, is fulfilled. The factor X may be set in view of the configuration of the system 304, e.g. in view of the length of the HVDC line 310 to which the method is applied. Further, the method may comprise the step of comparing the voltage of the period of time, e.g. 1 ms, or 2 ms, or any suitable period of time, with a set voltage level, or voltage threshold Y, at step 510, and the stage of detecting a fault on the internal part may at least partially be based on the comparison of the voltage and the set voltage level during the period of time. Advantageously, a fault on the internal part may be detected if a second criterion, namely that the voltage during the period of time is below the set voltage level Y, is fulfilled, at step 512. The voltage level *Y* may be set in view of the configuration of the system 304, e.g. in view of the length of the HVDC line 310 to which the method is applied. Advantageously, as schematically shown in Fig. 11, the fulfilment of the first criterion is checked, or verified, prior to checking the fulfilment of the second criterion. However, the fulfilment of the second criterion may be checked, or verified, prior to checking the fulfilment of the first criterion. The second criterion and the steps associated therewith may be excluded from the method. Additional criterion or criteria may also be added and used for detecting a fault on the internal part. When a fault on the internal part, i.e. an internal fault, has been detected, the internal fault may be dealt with in manners known to the skilled person, e.g. by disconnecting the faulty internal part or the faulty HVDC line.

The stage of detecting a fault on the internal part may comprise detecting a fault on an internal part comprising at least one overhead line, or at least one cable, or any other line, or a mixture thereof.

By using the derivative of the impedance as a basis for detecting a fault on the internal part and for discriminating between a fault on the internal part and a fault on the external part, an efficient and robust method for detecting a fault on the internal part is provided, especially when the internal part comprises a long-distance HVDC line.

The invention shall not be considered limited to the embodiments illustrated, but can be modified and altered in many ways by one skilled in the art, without departing from the scope of the appended claims.

**Claims**

1. A method for detecting a fault in a high voltage direct current, HVDC, power transmission system, the system comprising an internal part and an external part for carrying direct current, DC, where the internal part comprises at least one HVDC transmission or distribution line for carrying direct current, and the external part is separated from the internal part by means of at least one inductor, the method comprising the steps of:

   - determining the current (502) carried by the HVDC transmission or distribution line,
   - determining the voltage (502) at a first location of the HVDC power transmission system, the first location being provided at one end of said HVDC transmission and distribution line and said inductor being connected at the other end of the HVDC transmission or distribution line,
   - determining the impedance (504) based on the determined current and voltage,
   - determining the derivative of the impedance (506), and
   - detecting a fault (512) on the internal part at least partially based on the derivative of the impedance.

**2.** A method according to claim 1, **characterized in that** the method comprises determining the current and the voltage (502) during a period of time and determining the impedance (504) for the period of time, **in that** the method comprises determining the derivative of the impedance (506) for the period of time, and **in that** the derivative of the impedance for the period of time is used at least partially as a basis for detecting a fault (512) on the internal part.

**3.** A method according to claim 2, **characterized in that** the step of detecting a fault (512) on the internal part comprises detecting a drop of the derivative of the impedance (508) for the period of time, and **in that** the drop of the derivative of the impedance is used at least partially as a basis for detecting a fault on the internal part.

**4.** A method according to claim 3, **characterized in that** a fault on the internal part is detected (512) if a first criterion, namely that when dropping, the derivative of the impedance drops by a set factor ($X$), is fulfilled.

**5.** A method according to claim 4, **characterized in that** the method comprises determining the voltage (502) at a location of the HVDC power transmission system during the period of time, and comparing the voltage (510) of the period of time with a set voltage level ($Y$), and **in that** the step of detecting a fault (512) on the internal part is at least partially based on the comparison of the voltage during the period of time and the set voltage level.

**6.** A method according to claim 5, **characterized in that** a fault on the internal part is detected (512) if a second criterion, namely that the voltage during the period of time is below the set voltage level ($Y$), is fulfilled.

**7.** A method according to any of the claims 1 to 6, **characterized in that** the step of determining the current (502) comprises measuring the current carried by the HVDC transmission or distribution line.

**8.** A method according to any of the claims 1 to 7, **characterized in that** the step of determining the voltage (502) comprises measuring the voltage at the first location of the HVDC power transmission system.

**9.** A method according to claim 8, **characterized in that** the step of measuring the voltage comprises measuring the voltage at a first location on the internal part.

**10.** A method according to any of the claims 1 to 9, **characterized in that** the step of detecting a fault (512) on the internal part comprises detecting a fault on an internal part comprising at least one overhead line.

**11.** An apparatus (302) for detecting a fault in a high voltage direct current, HVDC, power transmission system (304), the system comprising an internal part (306) and an external part (308) for carrying direct current, DC, where the internal part comprises at least one HVDC transmission or distribution line (310) for carrying direct current, and the external part is separated from the internal part by means of at least one inductor (312), the apparatus comprising fault detection means (346) for detecting a fault on the internal part, current determination means (330) for determining the current carried by the HVDC transmission or distribution line, and voltage determination means (334) for determining the voltage at a first location (336) of the HVDC power transmission system, where the first location is provided at one end of said HVDC transmission and distribution line and said inductor being connected at the other end of the HVDC transmission or distribution line, **characterized in that** the apparatus comprises impedance determination means (342) for determining the impedance based on the determined current and voltage, and derivative determination means (344) for determining the derivative of the impedance, and **in that** the fault detection means are arranged to detect a fault on the internal part at least partially based on the derivative of the impedance.

**12.** An apparatus according to claim 11, **characterized in that** the current and voltage determination means (330, 334) are arranged to determine the current and the voltage, respectively, **in that** the impedance determination means (342) are arranged to determine the impedance for the period of time, **in that** the derivative determination means (344) are arranged to determine the derivative of the impedance for the period of time, and **in that** the fault detection means (346) are arranged to detect a fault on the internal part (306) at least partially based on the derivative of the impedance for the period of time.

**13.** An apparatus according to claim 12, **characterized in that** the fault detection means (346) are arranged to detect a drop of the derivative of the impedance for the period of time, and **in that** the fault detection means are arranged to detect a fault on the internal part (306) at least partially based on the drop of the derivative of the impedance.

14. An apparatus according to claim 13, **characterized in that** the fault detection means (346) are arranged to detect a fault on the internal part (306) if a first criterion, namely that when dropping, the derivative of the impedance drops by a set factor (*X*), is fulfilled.

15. An apparatus according to claim 14, **characterized in that** the voltage determination means (334) are arranged to determine the voltage at a location (336) of the HVDC power transmission system during the period of time, **in that** the fault detection means (346) comprise comparison means (348) for comparing the voltage of the period of time with a set voltage level (*Y*), and **in that** the fault detection means are arranged to detect a fault on the internal part (306) at least partially based on the comparison of the voltage of the period of time and the set voltage level.

16. An apparatus according to claim 15, **characterized in that** the fault detection means (346) are arranged to detect a fault on the internal part (306) if a second criterion, namely that the voltage during the period of time is below the set voltage level (*Y*), is fulfilled.

17. An apparatus according to any of the claims 11 to 16, **characterized in that** the fault detection means (346) are arranged to detect a fault on an internal part (306) comprising at least one overhead line.

18. A high voltage direct current, HVDC, power transmission system (304) comprising an internal part (306) and an external part (308) for carrying direct current, DC, where the internal part comprises at least one HVDC transmission or distribution line (310, 314, 316, 318, 320) for carrying direct current, and the external part is separated from the internal part by means of at least one inductor (312), the system comprising at least one converter station (322, 324, 326, 328) arranged to convert alternating current, AC, to direct current for input to the at least one HVDC transmission or distribution line, and/or direct current to alternating current, wherein a first location is provided at one end of said HVDC transmission and distribution line and said inductor is connected at the other end of the HVDC transmission or distribution line and the system comprises at least one apparatus (302) as claimed in any of the claims 11-17.

**Patentansprüche**

1. Verfahren zum Detektieren eines Fehlers in einem Hochspannungs-Gleichstrom-Übertragungssystem (HVDC-Übertragungssystem), wobei das System einen inneren Teil und einen äußeren Teil zum Führen von Gleichstrom, DC, umfasst, wobei der innere Teil mindestens eine HVDC-Übertragungs- oder -Verteilungsleitung zum Führen von Gleichstrom umfasst, und der äußere Teil durch mindestens einen Induktor von dem inneren Teil abgetrennt ist, wobei das Verfahren folgende Schritte umfasst:

   • Bestimmen des Stroms (502), der von der HVDC-Übertragungs- oder -Verteilungsleitung geführt wird,
   • Bestimmen der Spannung (502) an einer ersten Position des HVDC-Übertragungssystems, wobei die erste Position an einem Ende der HVDC-Übertragungs- und -Verteilungsleitung vorgesehen ist und der Induktor mit dem anderen Ende der HVDC-Übertragungs- oder -Verteilungsleitung verbunden ist,
   • Bestimmen der Impedanz (504) basierend auf dem bestimmten Strom und der bestimmten Spannung,
   • Bestimmen der Ableitung der Impedanz (506), und
   • Detektieren eines Fehlers (512) in dem inneren Teil zumindest teilweise basierend auf der Ableitung der Impedanz.

2. Verfahren nach Anspruch 1, **dadurch gekennzeichnet, dass** das Verfahren das Bestimmen des Stroms und der Spannung (502) in einem Zeitraum und das Bestimmen der Impedanz (504) für den Zeitraum umfasst, dass das Verfahren das Bestimmen der Ableitung der Impedanz (506) für den Zeitraum umfasst und dass die Ableitung der Impedanz für den Zeitraum zumindest teilweise als Grundlage zum Detektieren eines Fehler (512) in dem inneren Teil verwendet wird.

3. Verfahren nach Anspruch 2, **dadurch gekennzeichnet, dass** der Schritt des Detektierens eines Fehlers (512) in dem inneren Teil das Detektieren eines Abfallens der Ableitung der Impedanz (508) für den Zeitraum umfasst und dass das Abfallen der Ableitung der Impedanz für den Zeitraum zumindest teilweise als Grundlage zum Detektieren eines Fehlers (512) in dem inneren Teil verwendet wird.

4. Verfahren nach Anspruch 3, **dadurch gekennzeichnet, dass** ein Fehler in dem inneren Teil detektiert wird (512), wenn ein erstes Kriterium, nämlich, dass dann, wenn das Abfallen der Ableitung der Impedanz um einen vorgegebenen Faktor (X) abfällt, erfüllt ist.

5. Verfahren nach Anspruch 4, **dadurch gekennzeichnet, dass** das Verfahren das Bestimmen der Spannung (502) an einer Position des HVDC-Übertragungssystems in dem Zeitraum und das Vergleichen der Spannung (510) des Zeitraums mit einem vorgegebenen Spannungspegel (Y) umfasst und dass der Schritt des Detektierens eines Fehlers (512) in dem inneren Teil zumindest teilweise auf dem Vergleich der Spannung in dem Zeitraum und dem vorgegebenen Spannungspegel basiert.

6. Verfahren nach Anspruch 5, **dadurch gekennzeichnet, dass** ein Fehler in dem inneren Teil detektiert wird (512), wenn ein zweites Kriterium, nämlich, dass die Spannung in dem Zeitraum unterhalb des vorgegebenen Spannungspegels (Y) liegt, erfüllt ist.

7. Verfahren nach einem der Ansprüche 1 bis 6, **dadurch gekennzeichnet, dass** der Schritt des Bestimmens des Stroms (502) das Messen des Stroms, der von der HVDC-Übertragungs- oder Verteilungsleitung geführt wird, umfasst.

8. Verfahren nach einem der Ansprüche 1 bis 7, **dadurch gekennzeichnet, dass** der Schritt des Bestimmens der Spannung (502) das Messen der Spannung an der ersten Position des HVDC-Übertragungssystems umfasst.

9. Verfahren nach Anspruch 8, **dadurch gekennzeichnet, dass** der Schritt des Messens der Spannung das Messen der Spannung an einer ersten Position in dem inneren Teil umfasst.

10. Verfahren nach einem der Ansprüche 1 bis 9, **dadurch gekennzeichnet, dass** der Schritt des Detektierens eines Fehlers (512) in dem inneren Teil das Detektieren eines Fehlers in einem inneren Teil umfasst, das mindestens eine Freileitung umfasst.

11. Vorrichtung (302) zum Detektieren eines Fehlers in einem Hochspannungs-Gleichstrom-Übertragungssystem (HVDC-Übertragungssystem) (304), wobei das System einen inneren Teil (306) und einen äußeren Teil (308) zum Führen von Gleichstrom, DC, umfasst, wobei der innere Teil mindestens eine HVDC-Übertragungs- oder -Verteilungsleitung (310) zum Führen von Gleichstrom umfasst, und der äußere Teil durch mindestens einen Induktor (312) von dem inneren Teil abgetrennt ist, wobei die Vorrichtung Folgendes umfasst:

Fehlerdetektionsmittel (346) zum Detektieren eines Fehlers in dem inneren Teil,
Strombestimmungsmittel (330) zum Bestimmen des Stroms, der von der HVDC-Übertragungs- oder -Verteilungsleitung geführt wird, und
Spannungsbestimmungsmittel (334) zum Bestimmen der Spannung an einer ersten Position (336) des HVDC-Übertragungssystems, wobei die erste Position an einem Ende der HVDC-Übertragungs- und -Verteilungsleitung vorgesehen ist und der Induktor mit dem anderen Ende der HVDC-Übertragungs- oder -Verteilungsleitung verbunden ist, **dadurch gekennzeichnet, dass** die Vorrichtung Folgendes umfasst:

Impedanzbestimmungsmittel (342) zum Bestimmen der Impedanz basierend auf dem bestimmten Strom und der bestimmten Spannung, und
Ableitungsbestimmungsmittel (344) zum Bestimmen der Ableitung der Impedanz (506), und dass die Fehlerbestimmungsmittel dafür ausgelegt sind, zumindest teilweise basierend auf der Ableitung der Impedanz einen Fehler in dem inneren Teil zu bestimmen.

12. Vorrichtung nach Anspruch 11, **dadurch gekennzeichnet, dass** die Strom- und Spannungsbestimmungsmittel (330, 334) dafür ausgelegt sind, den Strom bzw. die Spannung zu bestimmen, dass die Impedanzbestimmungsmittel (342) dafür ausgelegt sind, die Impedanz für den Zeitraum zu bestimmen, dass die Ableitungsbestimmungsmittel (344) dafür ausgelegt sind, die Ableitung der Impedanz für den Zeitraum zu bestimmen, und dass die Fehlerdetektionsmittel (346) dafür ausgelegt sind, zumindest teilweise basierend auf der Ableitung der Impedanz für den Zeitraum einen Fehler in dem inneren Teil (306) zu bestimmen.

13. Vorrichtung nach Anspruch 12, **dadurch gekennzeichnet, dass** die Fehlerdetektionsmittel (346) dafür ausgelegt sind, ein Abfallen der Ableitung der Impedanz für den Zeitraum zu detektieren, und dass die Fehlerdetektionsmittel dafür ausgelegt sind, zumindest teilweise auf dem Abfallen der Ableitung der Impedanz basierend einen Fehler in dem inneren Teil (306) zu detektieren.

**14.** Vorrichtung nach Anspruch 13, **dadurch gekennzeichnet, dass** die Fehlerdetektionsmittel (346) dafür ausgelegt sind, einen Fehler in dem inneren Teil (306) zu detektieren, wenn ein erstes Kriterium, nämlich, dass dann, wenn das Abfallen der Ableitung der Impedanz um einen vorgegebenen Faktor (X) abfällt, erfüllt ist.

**15.** Vorrichtung nach Anspruch 14, **dadurch gekennzeichnet, dass** die Spannungsbestimmungsmittel (334) dafür ausgelegt sind, die Spannung an einer Position (336) des HVDC-Übertragungssystems in dem Zeitraum zu bestimmen, dass die Fehlerdetektionsmittel (346) Vergleichsmittel (348) zum Vergleichen der Spannung des Zeitraums mit einem vorgegebenen Spannungspegel (Y) umfassen und dass die Fehlerdetektionsmittel dafür ausgelegt sind, zumindest teilweise basierend auf dem Vergleich der Spannung des Zeitraums und dem vorgegebenen Spannungspegel einen Fehler in dem inneren Teil (306) zu detektieren.

**16.** Vorrichtung nach Anspruch 15, **dadurch gekennzeichnet, dass** die Fehlerdetektionsmittel (346) dafür ausgelegt sind, einen Fehler in dem inneren Teil (306) zu detektieren, wenn ein zweites Kriterium, nämlich, dass die Spannung in dem Zeitraum unterhalb des vorgegebenen Spannungspegels (Y) liegt, erfüllt ist.

**17.** Vorrichtung nach einem der Ansprüche 11 bis 16, **dadurch gekennzeichnet, dass** die Fehlerdetektionsmittel (346) dafür ausgelegt sind, einen Fehler in einem inneren Teil (306) zu detektieren, das mindestens eine Freileitung umfasst.

**18.** Hochspannungs-Gleichstrom-Übertragungssystem (HVDC-Übertragungssystem) (304), das einen inneren Teil (306) und einen äußeren Teil (308) zum Führen von Gleichstrom, DC, umfasst, wobei der innere Teil mindestens eine HVDC-Übertragungs- oder -Verteilungsleitung (310, 314, 316, 318, 320) umfasst und der äußere Teil durch mindestens einen Induktor (312) von dem inneren Teil abgetrennt ist, wobei das System mindestens eine Stromrichterstation (322, 324, 326, 328) umfasst, die dafür ausgelegt ist, Wechselstrom, AC, in Gleichstrom für die Zufuhr in die mindestens eine HVDC-Übertragungs- oder -Verteilungsleitung, und/oder Gleichstrom in Wechselstrom umzuwandeln, wobei eine erste Position an einem Ende der HVDC-Übertragungs- und -Verteilungsleitung vorgesehen ist und der Induktor mit dem anderen Ende der HVDC-Übertragungs- oder -Verteilungsleitung verbunden ist und das System mindestens eine Vorrichtung (302) nach einem der Ansprüche 11-17 umfasst.

**Revendications**

**1.** Procédé pour détecter un défaut dans un système de transport d'énergie en courant continu haute tension, CCHT, le système comprenant une partie interne et une partie externe pour acheminer du courant continu, CC, la partie interne comprenant au moins une ligne de transport ou de distribution CCHT pour acheminer du courant continu et la partie externe étant séparée de la partie interne au moyen d'au moins une inductance, le procédé comprenant les étapes consistant à :

• déterminer le courant (502) acheminé par la ligne de transport ou de distribution CCHT,
• déterminer la tension (502) à un premier emplacement du système de transport d'énergie CCHT, le premier emplacement étant prévu à une extrémité de ladite ligne de transport et de distribution CCHT et ladite inductance étant reliée à l'autre extrémité de la ligne de transport ou de distribution CCHT,
• déterminer l'impédance (504) en fonction du courant et de la tension déterminés,
• déterminer la dérivée de l'impédance (506), et
• détecter un défaut (512) sur la partie interne en fonction tout au moins partiellement de la dérivée de l'impédance.

**2.** Procédé selon la revendication 1, **caractérisé en ce qu'**il comprend les étapes consistant à déterminer le courant et la tension (502) au cours d'une période de temps et à déterminer l'impédance (504) pour la période de temps, **en ce qu'**il comprend l'étape consistant à déterminer la dérivée de l'impédance (506) pour la période de temps, et **en ce que** la dérivée de l'impédance pour la période de temps sert tout au moins partiellement de base pour détecter un défaut (512) sur la partie interne.

**3.** Procédé selon la revendication 2, **caractérisé en ce que** l'étape consistant à détecter un défaut (512) sur la partie interne comprend l'étape consistant à détecter une chute de la dérivée de l'impédance (508) pour la période de temps, et **en ce que** la chute de la dérivée de l'impédance sert tout au moins partiellement de base pour détecter un défaut sur la partie interne.

**4.** Procédé selon la revendication 3, **caractérisé en ce qu'**un défaut sur la partie interne est détecté (512) si un premier critère est rempli, à savoir que, lorsqu'elle chute, la dérivée de l'impédance chute d'un facteur défini (X).

5. Procédé selon la revendication 4, **caractérisé en ce qu'**il comprend les étapes consistant à déterminer la tension (502) à un emplacement du système de transport d'énergie CCHT au cours de la période de temps, et à comparer la tension (510) de la période de temps à un niveau de tension défini (Y), et **en ce que** l'étape consistant à détecter un défaut (512) sur la partie interne est fonction tout au moins partiellement de la comparaison de la tension au cours de la période de temps et du niveau de tension défini.

6. Procédé selon la revendication 5, **caractérisé en ce qu'**un défaut sur la partie interne est détecté (512) si un second critère est rempli, à savoir que la tension, au cours de la période de temps, est inférieure au niveau de tension défini (Y).

7. Procédé selon l'une quelconque des revendications 1 à 6, **caractérisé en ce que** l'étape consistant à déterminer le courant (502) comprend l'étape consistant à mesurer le courant acheminé par la ligne de transport ou de distribution CCHT.

8. Procédé selon l'une quelconque des revendications 1 à 7, **caractérisé en ce que** l'étape consistant à déterminer la tension (502) comprend l'étape consistant à mesurer la tension au premier emplacement du système de transport d'énergie CCHT.

9. Procédé selon la revendication 8, **caractérisé en ce que** l'étape consistant à mesurer la tension comprend l'étape consistant à mesurer la tension à un premier emplacement sur la partie interne.

10. Procédé selon l'une quelconque des revendications 1 à 9, **caractérisé en ce que** l'étape consistant à détecter un défaut (512) sur la partie interne comprend l'étape consistant à détecter un défaut sur une partie interne comprenant au moins une ligne aérienne.

11. Appareil (302) pour détecter un défaut dans un système de transport d'énergie en courant continu haute tension, CCHT, (304), le système comprenant une partie interne (306) et une partie externe (308) pour acheminer du courant continu, CC, la partie interne comprenant au moins une ligne de transport ou de distribution CCHT (310) pour acheminer du courant continu et la partie externe étant séparée de la partie interne au moyen d'au moins une inductance (312), l'appareil comprenant
un moyen de détection de défaut (346) pour détecter un défaut sur la partie interne,
un moyen de détermination de courant (330) pour déterminer le courant acheminé par la ligne de transport ou de distribution CCHT, et
un moyen de détermination de tension (334) pour déterminer la tension à un premier emplacement (336) du système de transport d'énergie CCHT, le premier emplacement étant prévu à une extrémité de ladite ligne de transport et de distribution CCHT et ladite inductance étant reliée à l'autre extrémité de la ligne de transport ou de distribution CCHT, l'appareil étant **caractérisé en ce qu'**il comprend
un moyen de détermination d'impédance (342) pour déterminer l'impédance en fonction du courant et de la tension déterminés, et
un moyen de détermination de dérivée (344) pour déterminer la dérivée de l'impédance, et **en ce que** le moyen de détection de défaut est conçu pour détecter un défaut sur la partie interne en fonction tout au moins partiellement de la dérivée de l'impédance.

12. Appareil selon la revendication 11, **caractérisé en ce que** les moyens de détermination de courant et de tension (330, 334) sont conçus pour déterminer respectivement le courant et la tension, **en ce que** le moyen de détermination d'impédance (342) est conçu pour déterminer l'impédance pour la période de temps, **en ce que** le moyen de détermination de dérivée (344) est conçu pour déterminer la dérivée de l'impédance pour la période de temps, et **en ce que** le moyen de détection de défaut (346) est conçu pour détecter un défaut sur la partie interne (306) en fonction tout au moins partiellement de la dérivée de l'impédance pour la période de temps.

13. Appareil selon la revendication 12, **caractérisé en ce que** le moyen de détection de défaut (346) est conçu pour détecter une chute de la dérivée de l'impédance pour la période de temps, et **en ce que** le moyen de détection de défaut est conçu pour détecter un défaut sur la partie interne (306) en fonction tout au moins partiellement de la chute de la dérivée de l'impédance.

14. Appareil selon la revendication 13, **caractérisé en ce que** le moyen de détection de défaut (346) est conçu pour détecter un défaut sur la partie interne (306) si un premier critère est rempli, à savoir que, lorsqu'elle chute, la dérivée de l'impédance chute d'un facteur défini (X).

15. Appareil selon la revendication 14, **caractérisé en ce que** le moyen de détermination de tension (334) est conçu pour déterminer la tension à un emplacement (336) du système de transport d'énergie CCHT au cours de la période de temps, **en ce que** le moyen de détection de défaut (346) comprend un moyen de comparaison (348) pour comparer la tension de la période de temps à un niveau de tension défini (Y), et **en ce que** le moyen de détection de défaut est conçu pour détecter un défaut sur la partie interne (306) en fonction tout au moins partiellement de la comparaison de la tension de la période de temps et du niveau de tension défini.

16. Appareil selon la revendication 15, **caractérisé en ce que** le moyen de détection de défaut (346) est conçu pour détecter un défaut sur la partie interne (306) si un second critère est rempli, à savoir que la tension, au cours de la période de temps, est inférieure au niveau de tension défini (Y).

17. Appareil selon l'une quelconque des revendications 11 à 16, **caractérisé en ce que** le moyen de détection de défaut (346) est conçu pour détecter un défaut sur une partie interne (306) comprenant au moins une ligne aérienne.

18. Système de transport d'énergie en courant continu haute tension, CCHT, (304) comprenant une partie interne (306) et une partie externe (308) pour acheminer du courant continu, CC, la partie interne comprenant au moins une ligne de transport ou de distribution CCHT (310, 314, 316, 318, 320) pour acheminer du courant continu et la partie externe étant séparée de la partie interne au moyen d'au moins une inductance (312), le système comprenant au moins un poste de conversion (322, 324, 326, 328) conçu pour convertir du courant alternatif, CA, en du courant continu destiné à être envoyé dans ladite au moins une ligne de transport ou de distribution CCHT et/ou du courant continu en du courant alternatif, un premier emplacement étant prévu à une extrémité de ladite ligne de transport et de distribution CCHT et ladite inductance étant reliée à l'autre extrémité de la ligne de transport ou de distribution CCHT et le système comprenant au moins un appareil (302) selon l'une quelconque des revendications 11 à 17.

Fig. 1

Fig. 2

Fig. 3

Fig. 4

Fig. 6

Fig 8

Fig. 10

Determining the
current and the
voltage

502

Determining the
impedance

504

Determining the
derivative of the
impedance

506

Detecting a drop of
the derivative of
the impedance

508

The derivative of the
impedance drops by
a factor X?

YES          NO

Comparing the
voltage during a time
period with a set volt-
age level Y

510

The voltage is below
Y during the time
period?

YES          NO

A fault on the internal
part is detected!

512

Fig. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4719980 A
- US 20090085574 A
- GB 1297628 A
- WO 9963641 A

### Non-patent literature cited in the description

- **SHU HONGCHUN.** The identification of Internal and External Faults for ±800kV UHVDC Transmission Line based on Mathematical Morphology. Faculty of Electrical Engineering, Kunming University of Science and Technology, 288-292
- A protection system for long HVDC transmission lines. **NAIDOO D et al.** POWER ENGINEERING SOCIETY INAUGURAL CONFERENCE AND EXPOSITION IN AFRICA. IEEE, 11 July 2005, 150-155